(19) Europäisches Patentamt
European Patent Office
Office européen des brevets

(11) **EP 4 525 202 A1**

(12) **EUROPEAN PATENT APPLICATION**

(43) Date of publication:
**19.03.2025 Bulletin 2025/12**

(21) Application number: **24198133.1**

(22) Date of filing: **03.09.2024**

(51) International Patent Classification (IPC):
*H01P 5/107* (2006.01)   *H01Q 1/22* (2006.01)

(52) Cooperative Patent Classification (CPC):
**H01P 5/107; H01Q 1/2283**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.09.2023 US 202318466351**

(71) Applicant: **NXP USA, Inc.
Austin TX 78735 (US)**

(72) Inventors:
• **Vincent, Michael  B
5656AG Eindhoven (NL)**
• **Hayes, Scott M
5656AG Eindhoven (NL)**

(74) Representative: **Hardingham, Christopher Mark
NXP Semiconductors
Intellectual Property Group
Abbey House
25 Clarendon Road
Redhill, Surrey RH1 1QZ (GB)**

(54) **DEVICE PACKAGES WITH INTEGRATED MILLIMETER-WAVE REFLECTOR CAVITIES**

(57)    An electronic device assembly includes a cavity formed from two portions and includes a reflector configured to reflect wireless signals that lines the cavity. A first portion of the cavity is formed within a carrier substrate and a second portion of the cavity is formed by an electrically conductive structure bonded to the carrier substrate above the first portion. The second portion is encapsulated by molding material disposed on the carrier substrate. An antenna structure is disposed at one end of the cavity and oriented toward the reflector. The antenna structure is electrically coupled to an electronic device bonded to the carrier substrate that is also encapsulated by the molding material.

FIG. 1A

EP 4 525 202 A1

## Description

### TECHNICAL FIELD

Embodiments of the subject matter described herein relate to structures and devices for coupling millimeter-wave signals generated by electronic devices to external antenna structures.

### BACKGROUND

Miniaturized integrated circuits for millimeter-wave communications and other applications often must be coupled to antenna structures to function as intended. In some applications a launcher configured to couple millimeter-wave radiation is integrated in a device package or other assembly along with one or more millimeter-wave integrated circuits. In other applications, millimeter-wave integrated circuits are coupled to printed circuit boards that are provided with integrated millimeter-wave launchers that are designed to couple to millimeter-wave antenna structures.

### SUMMARY

In an example embodiment, a device assembly includes a first electronic device coupled to a carrier substrate, an enclosed cavity, an antenna structure, and an electrically conductive reflector within the enclosed cavity. The enclosed cavity has a first portion formed within the carrier substrate and a second portion formed within a volume of molding material. The antenna structure is electrically coupled to a first electronic device and disposed adjacent to the enclosed cavity and oriented toward an interior of the enclosed cavity. The electrically conductive reflector within the enclosed cavity is configured to direct electromagnetic signals toward or away from the antenna structure.

In another example embodiment, a method of forming a device assembly includes receiving a carrier substrate with a first open cavity. The carrier substrate has a first surface, a second surface opposite the first surface, and a first open cavity having electrically conductive walls. The first open cavity extending from the first surface of the carrier substrate toward the second surface. The method also includes disposing an electrically conductive structure that defines a second open cavity above the first open cavity; and bonding the conductive structure to the top surface of the carrier substrate such that the first open cavity forms a first portion of an enclosed cavity and the second open cavity forms a second portion of an enclosed cavity. The method also includes encapsulating the enclosed cavity within a volume of molding material disposed on the top surface of the carrier substrate. An antenna structure is electrically coupled to a first electronic device disposed on the carrier substrate and the antenna structure is disposed adjacent to the enclosed cavity and oriented toward an interior of the enclosed cavity. The enclosed cavity includes a conductive reflector that is configured to direct electromagnetic signals toward or away from the antenna structure.

### BRIEF DESCRIPTION OF THE DRAWINGS

The present disclosure is illustrated by way of examples, embodiments and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:

FIG. 1A is a cross-sectional view of a device package with an integrated antenna and launcher structure according to one or more embodiments;

FIG. 1B is a cross-sectional view of another device package with an integrated antenna and launcher structure according to one or more embodiments;

FIG. 2A is a cross-sectional view of another device package with an integrated antenna and launcher structure according to one or more embodiments;

FIGs. 2B, 2C, and 2D are, respectively, a cross-sectional view of another device package related to the device package of figure 2B, a plan view of a portion of the package of FIG. 2B, and a cross-sectional view of the features shown in FIG. 2C.

FIG. 3 is a process flow diagram illustrating an example process suitable for use in fabricating device packages according to one or more embodiments.

FIG. 4 is a cross-sectional view of another device package with an integrated antenna and launcher structure according to one or more embodiments.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose.

Directional references such as "top," "bottom," "left," "right," "above," "below," and so forth, unless otherwise stated, are not intended to require any preferred orientation and are made with reference to the orientation of the corresponding figure or figures for purposes of illustration.

Unless explicitly stated otherwise, the use of terms "approximately," "substantially" and similar terms in connection with dimensions, relative positioning, or orientation of various features indicates that the dimensions, positioning, or orientation of those features are subject to tolerances and/or expected process variations of equipment and processes chosen to form the described features. Unless explicitly stated otherwise, the use of terms "approximately," "substantially" and similar terms in connection measurable values or characteristics is subject to the expected measurement accuracy of equipment and methods used to measure those values or characteristics and/or within tolerance limits specified by technical standards applicable to the technologies described.

It will be appreciated that the steps of various processes described herein are non-limiting examples of suitable processes according to embodiments and are for the purposes of illustration. Embodiments herein may use any suitable processes including those that omit steps described herein, perform those steps and similar steps in different orders, and the like. It will also be appreciated that well-known features and techniques may be omitted for clarity.

It will be appreciated that although reference may be made to particular frequency ranges such as radio frequencies ("RF"), microwave frequencies ("MW"), and mm-Wave frequencies, that nothing herein is intended to limit embodiments to operation at any particular frequency range.

Miniaturization of radiofrequency and microwave electronics for generating and receiving wireless signals presents challenges because of the need for structures such as antennae to couple signals from packaged components (e.g., individual chips, systems on a chip, multichip packages, and the like) to free space. While it can be desirable to integrate such structures directly into a chip package doing so can significantly increase the package size because the minimum dimensions of an antenna and/or associated structures such as waveguides, transitions, and launchers are often comparable or significantly larger than the effective wavelength of the signals being transmitted. This can increase production costs and introduce undesirable geometric constraints on component placement within larger systems and devices. Some of these constraints are mitigated at higher frequencies such as the 30-300 GHz range ("millimeter waves", having free-space wavelengths between 1-10 mm) because the of the reduced size requirements of components such as antennae and waveguides in the millimeter-wave regime compared to lower frequency regimes (e.g., in the MHz range and lower). However, integration of millimeter-wave launchers and other structures can still significantly increase minimum package sizes relative to the size of individual integrated circuits.

Accordingly, embodiments herein enable the integration of structures for wireless communications into molded device assemblies (or "packages") while reducing overall package thickness when compared to other approaches. For example, the minimum package thickness required to include a reflecting cavity usable as a launcher for a millimeter-wave antenna structure can be reduced by forming a first portion of the cavity in a carrier substrate (e.g., a printed circuit board) and forming a second portion of the cavity within encapsulating material that forms the rest of a device package, as opposed to forming the cavity within only the substrate or within only the encapsulating material.

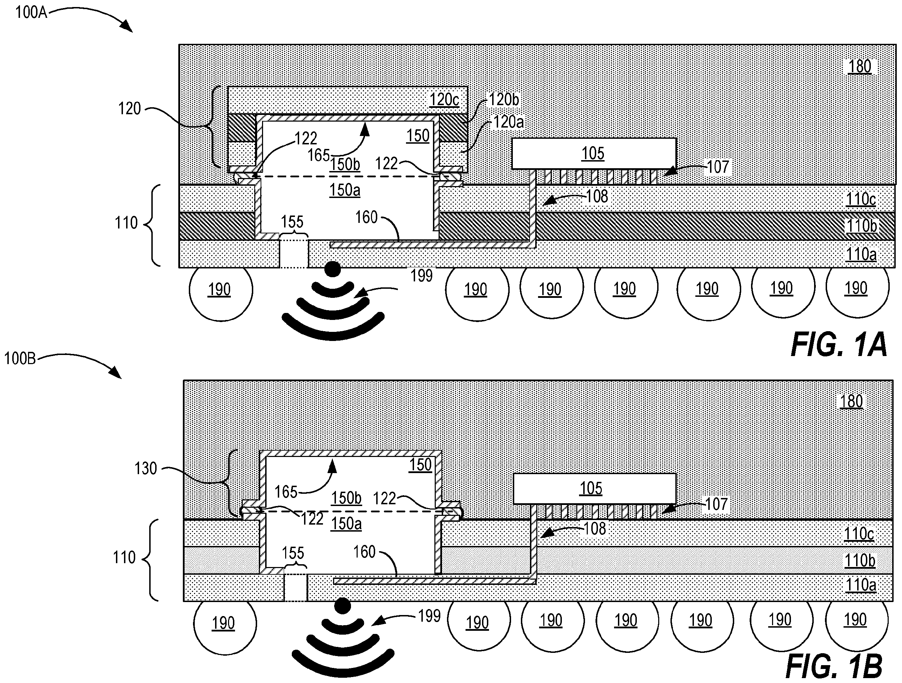

FIG. 1A is a cross-sectional view of an example package according to one or more embodiments. The package 100A includes a carrier substrate 110. In this example, the carrier substrate 110 is depicted as a three-layer printed circuit board in which the layers 110a, 110b. 110c are formed from a dielectric material (e.g., fiberglass, epoxy, fluoropolymers, combinations thereof, and/or other materials such as ceramic or glass. The layer 110 is a core layer which may have increased rigidity compared to the layers 110a, 110c.

The package 100A includes an electronic device 105 bonded to the carrier substrate 110 (i.e., mechanically and electrically coupled to bond pads or similar structures patterned on or within the top surface of the layer 110c), an enclosed cavity 150, and an antenna structure 160 electrically coupled to the electronic device 105 that is configured to radiate or receive wireless signals. A volume of molding material 180 overlies the electronic device 105, the carrier substrate 110, and the enclosed cavity 150. In one or more embodiments, the enclosed cavity 150 may be filled with a dielectric material that is a solid, porous, and/or a gel material. In one or more such embodiments, the enclosed cavity is filled with a material having a dielectric constant that is lower than the dielectric constant(s) of the surrounding materials that form the carrier substrate 110 and the volume of molding material 180. It will be appreciated that the term "enclosed" is used herein to indicate that the enclosed cavity 150 is substantially surrounded by electrically conductive materials which confine and/or reflect electromagnetic signals within the cavity.

The enclosed cavity 150 has two portions. A first portion 150a is formed within the carrier substrate 110 as shown, while a second portion 150b extends above the carrier substrate 110 into the volume of molding material 180, as shown. In the example of FIG. 1A, the second portion of the enclosed cavity 150 is formed by a cavity in a second substrate 120 which is encapsulated within the volume of molding material 180. The second portion 150b of the enclosed cavity 150 is metallized to have a conductive inner surface forming part of an electrically-contiguous reflector 165 that includes side-walls of the first portion 150a of the enclosed cavity 150. The enclosed cavity 150 includes an aperture (a breather hole 155) that passes through the carrier substrate 110. The breather hole 155 allows equalization of the atmospheric pressure inside the enclosed cavity 150 with the atmospheric pressure of the ambient environment surrounding the package.

The second substrate 120 can be formed similarly to the carrier substrate 110 (e.g., another printed circuit board which is solder bonded or otherwise bonded to the carrier substrate 110). In the example of FIG. 1A, the substrate 120 is depicted as a three-layer circuit board constructed similarly to the carrier substrate 110 with layers 120a, 120b, and 120c.

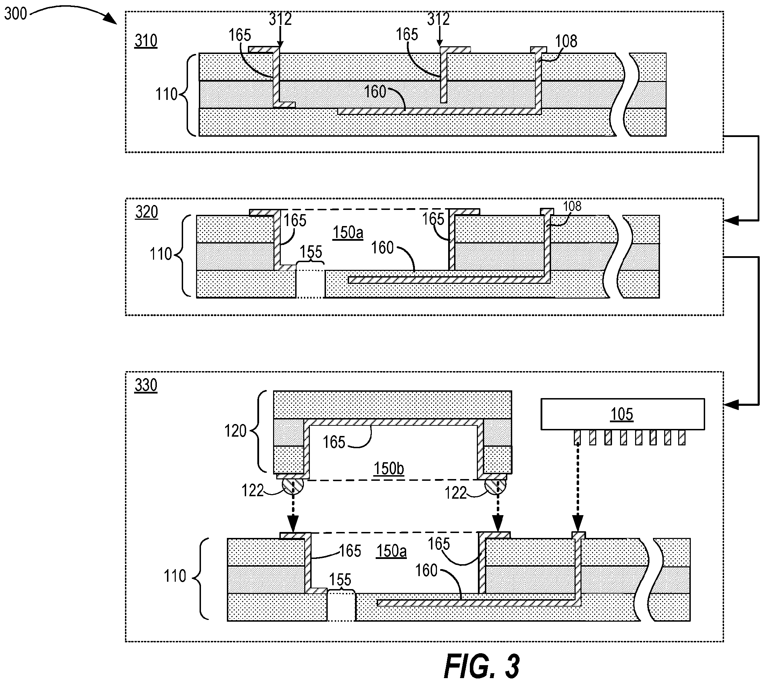

An enclosed cavity such as the enclosed cavity 150 can be formed by bonding a substrate such as the substrate 120 to a carrier substrate such as the carrier substrate 110 using any suitable methods including soldering, sintering, bonding with conductive adhesive, or the like. As shown, in FIG. 1A, the substrate 120 is bonded to the carrier substrate 110 via solder material 122. In this example, the solder material 122 forms a portion of the reflector 165. Formation of an enclosed cavity such as the enclosed cavity 150 is described further below in connection with FIG. 3. The solder material 122 can be configured to form a contiguous ring around the perimeter of the enclosed cavity 150.

A reflector such as the reflector 165 can be formed by depositing metal over a previously-formed cavity in a substrate such as the substrate 120. A reflector such as the reflector 165 can also be formed using existing techniques for forming conductive vias in printed circuit boards and conductive pads and traces on or within printed circuit boards, followed by selective removal of a portion of the substrate via etching, sawing, or any other suitable processes.

As shown, the antenna structure 160 is disposed opposite and adjacent to the 'U' shaped reflector 165. It will be appreciated that electromagnetic signals radiated from the antenna structure toward the reflector 165 will be reflected and redirected "downward" (i.e., toward the bottom of FIG. 1A), as represented schematically by the wireless signal 199. The reflector 165 can be made of any material or structure that reflects wireless signals at a desired operating frequency or range of operating frequencies. The antenna structure 160 is electrically coupled to the device 105 via an electrical interconnect 108 coupled to one of the conductive pillars 107. In this example the electrical interconnect 108 is formed as a conductive via that passes through the carrier substrate 110 and continues as a horizontal trace formed on or within the layer 110a of the carrier substrate 110.

FIG. 1B is a cross-sectional view of another example package according to one or more embodiments that is related to the example package 100A and includes similar components which are labeled identically to the corresponding components of the example package 100A as shown in FIG. 1A. The package 100B differs from the package 100A in that the second portion 150b of the enclosed cavity 150 is formed by a discrete conductive structure 130 rather than the substrate 120 of FIG. 1A. The conductive structure 130 can be formed of any suitable materials. For example, in one or more embodiments, a conductive structure such as the conductive structure 130 is preformed metal structure that can be attached to a bond pad on a carrier substrate such as the carrier substrate 110. As shown in FIG. 1B, the conductive structure 130 is bonded to the carrier substrate 110 via solder material 122 (analogously to the substrate 120 bonded to the carrier substrate 110 via the solder material 122 as shown in FIG. 1A).

For purposes of illustration, the electronic device 105 is depicted as a semiconductor device with conductive pillars 107 in FIG. 1A and FIG. 1B. However, the device 105 may be any suitable device, including an electronic device provided with solder pads, solder material, or other suitable electrical interconnection structures. It will be understood that the carrier substrate 110 and the second substrate 120 are depicted as three-layer substrates (e.g., printed circuit board substrates) for purposes of illustration only and that any suitable substrates may be used in embodiments herein.

It will be understood that in FIG. 1 and subsequent figures, the relative scale of various features may differ from actual implementations for purposes of illustration. For example, the relative width of breather holes such as the breather hole 155 may be exaggerated and the breather may be significantly smaller than depicted (e.g., significantly smaller than the operating wavelength of an antenna such as the antenna structure 160). As one non-limiting example, a breather hole such as the breather hole 155 may have a width that is one-tenth the operating wavelength or smaller. Similarly, the relative dimensions of solder structures such as solder bumps and the like (e.g., the cross-sections of the solder material 122) may be exaggerated relatively to other features.

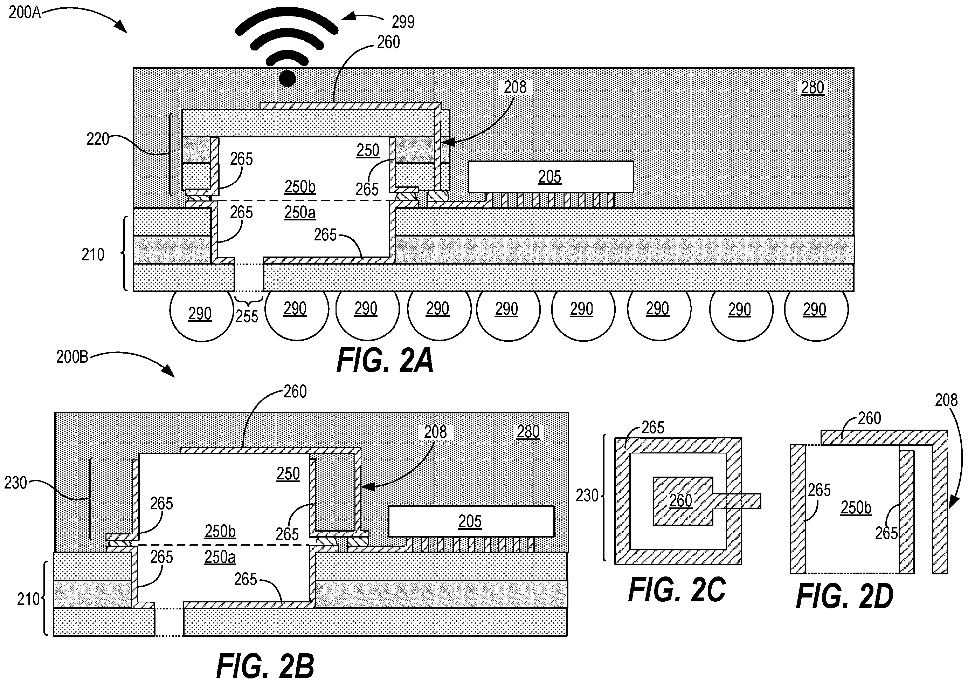

FIG. 2A is a cross-sectional view of an example package according to one or more embodiments. Analogously to the packages 100A, 100B, the package 200A has an enclosed cavity 250 that is formed from two portions and includes an electrically conductive reflector 265. The first portion 250a of the enclosed cavity 250 formed within a carrier substrate 210 (e.g., a carrier substrate 110) and a second portion 250b formed within a second substrate 220 that is bonded to the carrier substrate 210. An electronic device 205 (e.g., an electronic device 105) is bonded to the carrier substrate 210 and electrically coupled to an antenna structure 260 (e.g., an antenna structure 160) via an electrical interconnect 208. The second portion 250b of the enclosed cavity 250 and the electronic device 205 are encapsulated within a volume of molding material 280 (e.g., a volume of molding material 180) that encapsulates the second substrate 220 and the electronic device 205.

In the package 200A, the relative positions of the antenna structure 260 and the reflector 265 are reversed compared to the positions of the antenna structure 160 and the reflector 165 in the packages 100A, 100B. That is, the antenna structure 260 is disposed "over" the enclosed cavity 250 rather than "under" it (i.e., the antenna structure 260 is positioned directly adjacent to the second portion 250b of the enclosed cavity 250 rather than directly adjacent to the first portion 250a of the enclosed cavity 250). As illustrated by the wireless signal 299, the package 200A is configured such that electrical signals applied to the antenna structure 260 are directed "upward" as opposed to "downward" in the packages 100A, 100B.

FIG. 2B shows portions of a package 200B in which the antenna structure 260, the second portion of the enclosed cavity 250b, and the portion of the reflector 265 surrounding the second portion 250b of the enclosed cavity 250 is formed by a conductive structure 230 that is similar to the conductive structure 130. FIG. 2C shows a top plan view of the conductive structure 230 which includes the antenna structure 260 (depicted as a rectangular patch antenna) cantilevered over the reflector 265. FIG. 2D shows a cross-sectional elevation view of the conductive structure 230. It will be appreciated that, in one or more embodiments, a conductive structure such as the conductive structure 230 may include additional insulating features such as stand offs to provide mechanical support for the conductive structure 230 and electrical isolation of the antenna structure 260 from the reflector 265 prior to molding of the conductive structure 230 within the volume of molding material 280. Alternatively, in one or more embodiments, conductive structure such as the conductive structure 230 is provided as a partially pre-molded component which can be bonded to a carrier substrate such as the carrier substrate 210.

It will be appreciated that, in one or more embodiments, a package includes multiple hollow cavities, each with a corresponding reflector and antenna structure and that each antenna structure (and the corresponding cavity and reflector) can be configured to direct wireless signals in either upward or downward directions perpendicular to the thickness of the package. It will also be appreciated that although antenna structures (and associated structures such as hollow cavities and conductive reflectors) may be described herein as radiating or directing signals in a particular direction that such structures can also be used to direct externally-generated wireless signals toward an antenna structure. For example, an antenna structure that is configured to direct signals "upward" or "downward" can also be said to be configured to receive signals propagating in the opposite direction.

It will be understood than an antenna structure according to embodiments herein (e.g., an antenna structure 160 or 260) can have any suitable design. For example, an antenna structure such as an antenna structure 160 or 260 may be configured as a dipole antenna, a folded dipole antenna, a patch antenna, or an array of one more types of antenna elements, as nonlimiting examples. Along these lines, it will be understood that the dimensions of hollow cavities such as the enclosed cavity 150 or the enclosed cavity 250 can be chosen to achieve desired performance characteristics which will depend on an intended operating frequency of a corresponding antenna structure. For example, it can be desirable for a distance between an antenna structure (e.g., an antenna structure 160 or 260) and a conductive reflector (e.g., a reflector 165 or 265) in the direction of signal propagation to be equal to one-fourth the signal wavelength within the enclosed cavity (i.e., $\frac{\lambda}{4\sqrt{\epsilon_r}}$) where $\epsilon_r$ is the relative electric permittivity within the cavity (i.e., 1 for vacuum) As an example, the height of an enclosed cavity intended for use at a signal frequency of 77 GHz, can be as small as approximately 1 millimeter if the cavity is filled with air having a dielectric constant close to 1 and smaller if the cavity is filled with a dielectric material with a larger dielectric constant.

FIG. 3 illustrates steps in an example process suitable for use in forming a package such as the package 100A, 100B or 200, according to one or more embodiments. The example process 300 includes the steps 310, 320, and 330, which are illustrated by cross-sectional views and described below with reference to forming the package 100A.

At step 310, the carrier substrate 110 is received with the antenna structure 160 and the interconnect 108 formed as shown using any suitable techniques including well-known printed circuit board manufacturing methods The metal features 312 on the substrate 110 will form part of the reflector 165 as described below. At step 320, the first portion 150a of the enclosed cavity 150 is formed in the carrier substrate 110 by selectively removing the portions of the substrate 110 between the locations indicated by the arrows 312. For example, in one or more embodiments, the interconnect 108, the antenna structure 160, and the conductive features that will form part of the reflector 165 are formed as conductive surface traces and conductive vias of the carrier substrate 110, followed by selective removal of layers of the carrier substrate 110 to expose the first portion 150a of the enclosed cavity 150. Meanwhile, in one or more other embodiments, the carrier substrate 110 is selectively patterned to form the first portion 150a of the enclosed cavity 150 before formation of the antenna structure 160 and/or the portions of the reflector 165 disposed within the first portion 150a of the enclosed cavity 150. In one more such embodiments, all or part of the reflector 165 in the first portion 150a of the enclosed cavity 150 is formed by metallization of the exposed cavity (i.e., at step 320 or after step 320).

The first portion 150a of the enclosed cavity 150 may be formed using any suitable processes. For example, a lithographic process in which a masking material (e.g., photoresist) is patterned on the carrier substrate 110 and exposed portions of the carrier substrate 110 are selectively removed with one or more etchants, followed by a plating process may be used. In another example, all or part of the reflector 165 within the carrier substrate 110 can be formed via processes used for creation of vias, followed by removal of the portions of the carrier substrate 110 surrounded by the reflector 165 to form the first portion 150a of the enclosed cavity 150.

In the example process 300 as depicted in FIG. 3, the breather hole 155 is formed in the carrier substrate 110 at step 320, although it will be appreciated that breather holes such as the breather hole 155 can be formed at any suitable time during fabrication of a package such as the package 100A according to embodiments herein. Breather holes such as the breather hole 155 may be formed using any suitable methods including, but not limited to, etching, drilling, or laser ablation.

At step 330, the structure forming the second portion 150b of the enclosed cavity 150 (e.g., the second substrate 120) is bonded to the carrier substrate 110 forming the first portion 150a of the enclosed cavity 150. In the example of FIG. 3, the second substrate 120 (which has been previously patterned to form the second portion 150b of the enclosed cavity 150) is bonded to the carrier substrate 110 as shown. In this example, the electronic device 105 is also bonded to the carrier substrate 110 and electrically coupled to the antenna structure 160 via the electrical interconnect 108.

It will be appreciated that the example process 300 or similar processes can be used to form packages according to embodiments herein such as the packages 100B, 200A, or 200B. For example, the package 100B can be formed using the process 300 by replacing the second substrate 120 with the conductive structure 130. Similarly, the package 200A can be formed using the process 300 by altering the locations of the conductive material forming the reflector 165, the antenna structure 160, and the electrical interconnect 108, and related structures to instead form the reflector 265, the antenna structure 260, and the electrical interconnect 208 of the package 200A. Similarly, the package 200B can be formed by replacing the additional substrate 220 with the conductive structure 230.

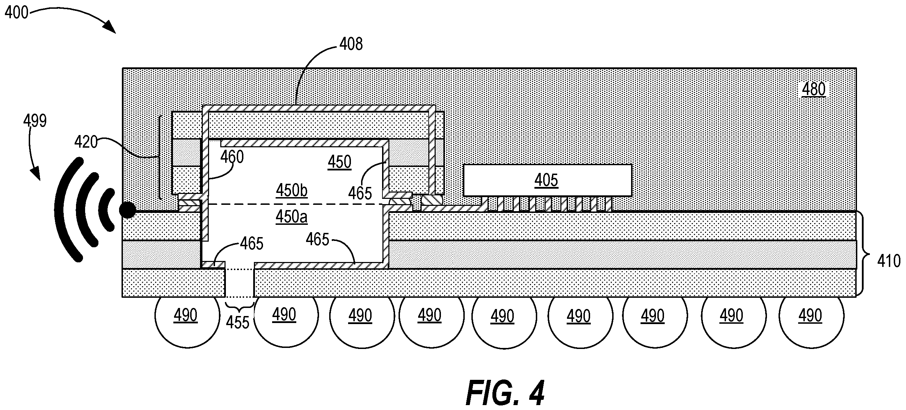

It will be further appreciated that embodiments herein are not limited to the "horizontally" oriented antennae 160, 260 (i.e., antennae with vertically-oriented radiation directions). Accordingly, FIG. 4 is a cross-sectional view of an example package according to one or more embodiments that includes a "vertical" antenna orientation (i.e., the antenna has a horizontally-oriented radiation direction). The package 400 has an enclosed cavity 450 that is formed from two portions and includes an electrically conductive reflector 465. The first portion 450a of the enclosed cavity 450 formed within a carrier substrate 410 (e.g., a carrier substrate 110 or 2120) and a second portion 450b formed within a second substrate 420 that is bonded to the carrier substrate 410. An electronic device 405 (e.g., an electronic device 105 or 205) is bonded to the carrier substrate 410 and electrically coupled to an antenna structure via an electrical interconnect 408. The second portion 450b of the enclosed cavity 450 and the electronic device 405 are encapsulated within a volume of molding material 480 (e.g., a volume of molding material 180 or 280) that encapsulates the second substrate 420 and the electronic device 405.

In the package 400, the relative positions of the antenna structure 460 and the reflector 465 are rotated compared to the positions of the antenna structure 160 and the reflector 165 in the packages 100A, 100B. That is, the antenna structure 460 is disposed along a vertical sidewall of the enclosed cavity 450 rather than "under" or "over" the enclosed cavity 450 and, as illustrated by the wireless signal 499, the package 400 is configured such that electrical signals applied to the antenna structure 460 are directed "sideways" as opposed to "downward" in the packages 100A, 100B or "upward" in the packages 200A, 200B.

In the example of FIG. 4, the antenna structure 460 is formed entirely in the additional substrate 420 and the additional substrate 420 is shown bonded to the carrier substrate 410 by a non-conductive adhesive 423 rather than solder or another electrically-conductive material in order to avoid interfering with performance of the antenna structure 460.

As above, it will be appreciated that various features are not drawn to scale. For example, the size of the solder bumps 490 are exaggerated in FIG. 4. Similarly, the distance between the bonded surfaces of a carrier substrate such as the carrier substrate 410 and an additional substrate such as the substrate 420 can be significantly smaller than shown in FIG. 4. Thus, it will be appreciated that, in one or more embodiments, an antenna structure such as the antenna structure 460 can include a portion (i.e., the dashed conductive element 461) that is formed on or within the carrier substrate. It will be appreciated that, in one or more such embodiments, a carrier substrate and an additional substrate can be bonded together such that a resulting antenna structure is effectively monolithic after the substrates have been bonded. For example, the two substrates can be joined by a thin layer of electrically conductive epoxy, electrically conductive paint, solder, or using any other suitable materials or processes such that the joint(s) between two portions of antenna structure do not impede operation of the antenna structure within a desired frequency range. It will be understood that in such embodiments, the distance between the two substrates will be much smaller than shown in FIG. 4.

It will also be appreciated that, in some embodiments, an antenna structure such as the antenna structure 460 (or an antenna structure 160 or 260 may differ from the structures shown and can include any suitable antenna structures. For instance, an antenna structures according to embodiments herein can include segmented antenna structures with more than one connection point or multiple segments (e.g., folded dipole antenna structures or segmented loop antenna structures), non-limiting examples. Antenna structures according to embodiments herein can also include, as further non-limiting examples, antenna structures that include additional conductive elements such as ground planes (e.g., microstrip-based antenna structures or strapline-based antenna structures) and the like.

It will also be appreciated that the routing of an interconnect such as the interconnect 408 may take different paths than the one shown in FIG. 4 to achieve desired performance characteristics of the antenna structure 460 or similar structures. Further, it will be understood that "vertical" antenna structures related to the structures of FIG. 4 can also be realized using standalone conductive structures in place of substrates such as the substrate 420 (e.g., the conductive structure 230 could be modified to form a vertical antenna structure and a corresponding reflector). As above, packages such as the package 400 can also be fabricated using a process similar to the process 300 with straightforward modifications.

## VARIOUS EXAMPLES

Features of embodiments may be understood by way of one or more of the following examples:

Example 1: A method or device that includes a first electronic device coupled to a carrier substrate, an enclosed cavity, an antenna structure, and an electrically conductive reflector within the enclosed cavity. The enclosed cavity has a first portion formed within the carrier substrate and a second portion formed within a volume of molding material. The antenna structure is electrically coupled to a first electronic device and disposed adjacent to the enclosed cavity and oriented toward an interior of the enclosed cavity. The electrically conductive reflector within the enclosed cavity is configured to direct electromagnetic signals toward or away from the antenna structure.

Example 2: The device or method of Example 1 that also includes an aperture in the carrier substrate that forms an open path between the interior of the enclosed cavity and an external environment surrounding the device.

Example 3: The device or method of Example 1 or Example 2, where electrically conductive reflector is formed by electrically conductive material lining the enclosed cavity and oriented opposite the antenna structure.

Example 4: The device or method of any of Examples 1-3, where the electrically conductive material is configured to reflect electromagnetic signals toward the antenna structure.

Example 5: The device or method of Examples 1-4 where the electrically conductive material lining the enclosed cavity includes a first section disposed within the first portion of the enclosed cavity and a second section disposed within the second portion of the enclosed cavity that is electrically contiguous with the first section.

Example 6: The device or method of Examples 1, that also includes an additional substate bonded to a first surface of the carrier substrate. The second portion of the enclosed cavity is formed within a cavity within the additional substate; and the additional substate is encapsulated within the volume of molding material.

Example 7: The device or method of any of Examples 1-6, where the antenna structure is formed by a conductive trace on or within an additional substrate. The antenna structure is separated from the electrically-conductive material in the second portion of the enclosed cavity by a layer of electrically-insulating material that forms part of the additional substrate.

Example 8: The device or method of any of Examples 1-7, where the antenna structure is disposed within the volume of molding material and is immediately adjacent to the second portion of the enclosed cavity.

Example 9: The device or method of any of Examples 1-7, where the antenna structure is disposed within the carrier substrate and is immediately adjacent to the first portion of the enclosed cavity.

The preceding detailed description and examples are merely illustrative in nature and are not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no Intention to be bound by any expressed or implied theory presented in the preceding technical field, background, or detailed description.

It should be understood that this invention is not limited in its application to the details of construction and the arrangement of components set forth in the preceding description or illustrated in the accompanying drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The preceding discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown, but are to be accorded the widest scope consistent with the principles and features disclosed herein. The preceding detailed description is to be read with reference to the figures, in which like elements in different figures have like reference numerals. The Figures, which are not necessarily to scale, depict selected embodiments and are not intended to limit the scope of embodiments of the invention. Skilled artisans will recognize the examples provided herein have many useful alternatives and fall within the scope of embodiments of the invention.

The connecting lines shown in the various figures contained herein are intended to represent exemplary functional relationships and/or physical couplings between the various elements. It should be noted that many alternative or additional functional relationships or physical connections may be present in one or more embodiments of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in one or more embodiments of the depicted subject matter.

## Claims

1. An electronic device assembly comprising:

    a first electronic device coupled to a carrier substrate;
    a volume of molding compound that encapsulates the first electronic device;
    an enclosed cavity having a first portion formed within the carrier substrate and a second portion formed within the volume of molding material;
    an antenna structure configured to be electrically coupled to a first electronic device and disposed adjacent to the enclosed cavity and oriented toward an interior of the enclosed cavity; and
    an electrically conductive reflector within the enclosed cavity that is configured to direct electromagnetic signals toward or away from the antenna structure.

2. The electronic device assembly of claim 1, further comprising an aperture in the carrier substrate that forms an open path between the interior of the enclosed cavity and an external environment surrounding the device.

3. The electronic device assembly of claim 1 or 2, wherein electrically conductive reflector is formed by electrically conductive material lining the enclosed cavity and oriented opposite the antenna structure.

**4.** The electronic device assembly of claim 3, wherein the electrically conductive material is configured to reflect electromagnetic signals toward the antenna structure.

**5.** The electronic device assembly of claim 3 or 4 wherein the electrically conductive material lining the enclosed cavity includes a first section disposed within the first portion of the enclosed cavity and a second section disposed within the second portion of the enclosed cavity that is electrically contiguous with the first section.

**6.** The electronic device assembly of any preceding claim, further comprising:

an additional substate bonded to a first surface of the carrier substrate;
wherein the second portion of the enclosed cavity is formed within a cavity within the additional substate; and
wherein the additional substate is encapsulated within the volume of molding material.

**7.** The electronic device assembly of claim 6,

wherein the antenna structure is formed by a conductive trace on or within the additional substrate; and
wherein the antenna structure is separated from the electrically-conductive material in the second portion of the enclosed cavity by a layer of electrically-insulating material that forms part of the additional substrate.

**8.** The electronic device assembly of any preceding claim, wherein the antenna structure is disposed within the volume of molding material and is immediately adjacent to the second portion of the enclosed cavity.

**9.** The electronic device assembly of any preceding claim, wherein the antenna structure is disposed within the carrier substrate and is immediately adjacent to the first portion of the enclosed cavity.

**10.** A method of forming an electronic device assembly,

receiving a carrier substrate having a first surface, a second surface opposite the first surface, and a first open cavity having electrically conductive walls, the first open cavity extending from the first surface of the carrier substrate toward the second surface;
disposing an electrically conductive structure that defines a second open cavity above the first open cavity;
bonding the conductive structure to the top surface of the carrier substrate such that the first open cavity forms a first portion of an enclosed cavity and the second open cavity forms a second portion of the enclosed cavity; and
encapsulating the enclosed cavity within a volume of molding material disposed on the top surface of the carrier substrate;
wherein an antenna structure is electrically coupled to a first electronic device disposed on the carrier substrate and the antenna structure is disposed adjacent to the enclosed cavity and oriented toward an interior of the enclosed cavity; and
wherein the enclosed cavity comprises a conductive reflector that is configured to direct electromagnetic signals toward or away from the antenna structure.

**11.** The method of claim 10, further comprising forming an aperture in the carrier substrate that forms an open path between an interior of the enclosed cavity and an external environment surrounding the device.

**12.** The method of claim 10 or 11, wherein the electrically conductive reflector is formed by electrically conductive material lining the enclosed cavity and oriented opposite the antenna structure.

**13.** The device of claim 12, wherein the electrically conductive material is configured to reflect electromagnetic signals toward the antenna structure.

**14.** The method of claim 12 or 13, further comprising electrically coupling a first section of the electrically conductive material disposed within the first portion of the enclosed cavity to a second section of the electrically conductive material disposed within the second portion of the enclosed cavity such the electrically conductive material lining the enclosed cavity is electrically contiguous.

**15.** The method of any one of claims 10 to 14,

wherein the conductive structure is formed within an additional substate bonded to a first surface of the carrier substrate; and
wherein bonding the conductive structure to the top surface of the carrier substrate comprises bonding the additional substate to the first surface of the carrier substrate.

FIG. 1A

FIG. 1B

**FIG. 2A**

**FIG. 2B**

**FIG. 2C**

**FIG. 2D**

**FIG. 3**

EP 4 525 202 A1

FIG. 4

EP 4 525 202 A1

Europäisches
Patentamt

European
Patent Office

Office européen
des brevets

# EUROPEAN SEARCH REPORT

Application Number

EP 24 19 8133

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2019/311998 A1 (ISHIBASHI DAIJIRO [JP]) 10 October 2019 (2019-10-10)<br>* paragraph [0032] - paragraph [0062]; figures 1, 5A-13 * | 1-6,9-15<br><br>7 | INV.<br>H01P5/107<br>H01Q1/22 |
| X | US 2021/218127 A1 (LAMPERSBERGER THOMAS [AT] ET AL) 15 July 2021 (2021-07-15)<br>* paragraph [0023] - paragraph [0046]; figures 1, 5A, 5B *<br>* paragraph [0048]; figure 7 * | 1-5,8,<br>10-14 | |
| X | US 2015/364830 A1 (TONG ZIQIANG [DE] ET AL) 17 December 2015 (2015-12-17)<br>* paragraphs [0026], [0033] - paragraph [0051]; figure 10 * | 1,3-5,9,<br>10,12-14 | |
| Y | DE KOK MARTIJN ET AL: "A Review of Design and Integration Technologies for D-Band Antennas",<br>IEEE OPEN JOURNAL OF ANTENNAS AND PROPAGATION, IEEE,<br>vol. 2, 14 June 2021 (2021-06-14), pages 746-758, XP011862011,<br>DOI: 10.1109/OJAP.2021.3089052<br>[retrieved on 2021-06-21]<br>* figure 5 * | 1,3,4,9,<br>10,12,13 | |
| Y | US 2021/175629 A1 (KANG KYUNG IN [KR] ET AL) 10 June 2021 (2021-06-10)<br>* paragraph [0060] - paragraph [0079]; figure 2B * | 1,3,4,9,<br>10,12,13 | |

**TECHNICAL FIELDS SEARCHED (IPC)**

H01P
H01Q

The present search report has been drawn up for all claims

| Place of search | Date of completion of the search | Examiner |
|---|---|---|
| The Hague | 15 January 2025 | Hueso González, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 24 19 8133

This annex lists the patent family members relating to the patent documents cited in the above-mentioned European search report.
The members are as contained in the European Patent Office EDP file on
The European Patent Office is in no way liable for these particulars which are merely given for the purpose of information.

15-01-2025

| Patent document cited in search report | Publication date | Patent family member(s) | Publication date |
|---|---|---|---|
| US 2019311998 A1 | 10-10-2019 | JP 6747301 B2 | 26-08-2020 |
| | | JP 2018113619 A | 19-07-2018 |
| | | US 2019311998 A1 | 10-10-2019 |
| | | WO 2018131452 A1 | 19-07-2018 |
| US 2021218127 A1 | 15-07-2021 | DE 102020112787 A1 | 29-07-2021 |
| | | US 2021218127 A1 | 15-07-2021 |
| US 2015364830 A1 | 17-12-2015 | NONE | |
| US 2021175629 A1 | 10-06-2021 | CN 110391494 A | 29-10-2019 |
| | | KR 20200008005 A | 22-01-2020 |
| | | US 2019326674 A1 | 24-10-2019 |
| | | US 2021175629 A1 | 10-06-2021 |

EPO FORM P0459

For more details about this annex : see Official Journal of the European Patent Office, No. 12/82